**Europäisches Patentamt**

**European Patent Office**

**Office européen des brevets**

(19)

(11) Numéro de publication: **0 157 697**
**B1**

(12) ## FASCICULE DE BREVET EUROPEEN

(45) Date de publication du fascicule du brevet:
**22.06.88**

(51) Int. Cl.⁴: **H 03 B 5/36, H 03 L 1/02**

(21) Numéro de dépôt: **85400568.3**

(22) Date de dépôt: **22.03.85**

(54) Oscillateur piézo-électrique fonctionnant en mode apériodique.

(30) Priorité: **27.03.84 FR 8404746**

(43) Date de publication de la demande:
**09.10.85 Bulletin 85/41**

(45) Mention de la délivrance du brevet:
**22.06.88 Bulletin 88/25**

(84) Etats contractants désignés:
**CH DE GB IT LI NL SE**

(56) Documents cités:
**FR - A - 2 501 435**
**US - A - 3 372 348**

(73) Titulaire: **COMPAGNIE D'ELECTRONIQUE ET DE PIEZO-ELECTRICITE - C.E.P.E., 44, rue de la Glacière, F-95100 Argenteuil (FR)**

(72) Inventeur: **Renoult, Patrick, THOMSON-CSF SCPI 173, bld Haussmann, F-75379 Paris Cedex 08 (FR)**
Inventeur: **Marotel, Gérard, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 19, avenue de Messine, F-75008 Paris (FR)**

# Description

La présente invention a pour objet un oscillateur piézo-électrique fonctionnant en mode apériodique, du type CLAPP.

On connaît de la demande de brevet français FR-A-2501435 déposée le 3 mars 1981 par la Demanderesse, un oscillateur piézo-électrique fonctionnant en mode apériodique du type Clapp, et comprenant un résonateur piézo-électrique présentant une fréquence de résonance à laquelle l'oscillateur doit fonctionner, ledit premier résonateur étant branché entre la base d'un transistor et la masse, ainsi qu'un pont diviseur capacitif présentant un point dit point milieu, et l'émetteur du transistor étant chargé par une résistance de charge.

On connaît aussi, par US-A-3372348, un oscillateur du type décrit ci-dessus et comprenant en outre un second résonateur piézo-électrique branché entre le point milieu du pont diviseur capacitif et l'émetteur du transistor.

Le but de l'invention est d'associer un tel oscillateur à un détecteur de température et un asservissement de la température du premier résonateur.

L'invention a donc pour objet un oscillateur piézo-électrique fonctionnant en mode apériodique, du type Clapp, comprenant un transistor, un pont diviseur capacitif branché entre la base dudit transistor et la masse et présentant un point dit point milieu, une résistance branchée entre l'émetteur du transistor et la masse, un premier résonateur piézo-électrique branché entre la base du transistor et la masse, ce résonateur présentant une fréquence de résonance à laquelle l'oscillateur dit oscillateur primaire doit fonctionner, un second résonateur piézo-électrique branché entre ledit point milieu et l'émetteur du transistor, ce second résonateur jouant le rôle de filtre passe-bande à la fréquence de fonctionnement de l'oscillateur et ayant en commun avec le premier résonateur un mode à ladite fréquence de résonance, cet oscillateur étant caractérisé en ce que le second résonateur a un facteur de qualité intrinsèque entre 30 et 1000 fois plus petit que celui du premier résonateur et que l'oscillateur possède un circuit de détection de la température et un circuit d'asservissement de la température du premier résonateur, ce premier résonateur présentant à ladite fréquence de résonance un mode de fréquence stable en fonction de la température ainsi qu'un mode dit thermométrique pour lequel la fréquence varie avec la température, le circuit de détection étant constitué par un oscillateur secondaire fonctionnant sur le mode thermométrique du premier résonateur et dont la fréquence varie en fonction de la température du premier résonateur, le circuit d'asservissement recevant, du circuit de détection, un signal représentatif de la variation de température du premier résonateur et délivrant, à une diode varicap placée dans la boucle d'oscillation de l'oscillateur primaire, un signal permettant de compenser la dérive en fréquence de l'oscillateur primaire.

L'invention sera mieux comprise à la lecture de la description qui va suivre, donnée à titre d'exemple non limitatif, en liaison avec les dessins qui représentent:

la fig. 1 un oscillateur selon un schéma de l'art connu;

la fig. 2 un mode de réalisation d'un oscillateur compensé en température selon un mode de réalisation de l'invention, et

la fig. 3, des courbes représentatives des dérives de fréquence en température dans le cas d'un quartz de coupe SC.

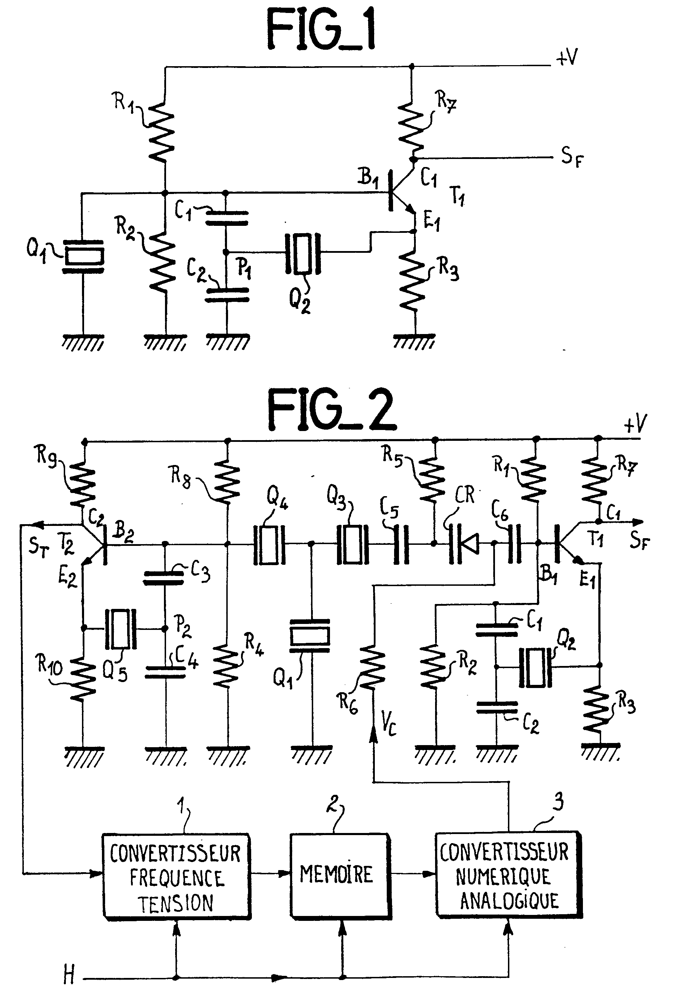

Selon la fig. 1 (voir aussi le brevet US-A-3372348), un transistor $T_1$ est alimenté à la tension $+V$ au niveau de son collecteur $C_1$, un pont diviseur R1, R2 polarisant sa base $B_1$. L'émetteur $E_1$ est chargé par une résistance de charge $R_3$. Le résonateur piézo-électrique $Q_1$ est branché entre la base $B_1$ du transistor $T_1$ et la masse. Un pont diviseur capacitif $C_1$, $C_2$ présentant un point dit point milieu $P_1$ est branché également entre la base $B_1$ du transistor $T_1$ et la masse. Un résonateur piézo-électrique $Q_2$ est branché entre le point milieu $P_1$ et l'émetteur $E_1$ du transistor $T_1$. La fonction de ce résonateur $Q_1$ est de réaliser un filtre passe-bande à la fréquence de fonctionnement de l'oscillateur. De ce fait, le résonateur $Q_2$ doit avoir un mode à la même fréquence que le mode du résonateur $Q_1$ choisi pour déterminer la fréquence de l'oscillateur. Le filtre passe-bande est réalisé en choisissant le résonateur $Q_2$ avec un facteur de qualité qui est de 30 à 1000 fois plus petit que celui du résonateur $Q_1$. De cette façon, on est sûr d'obtenir le démarrage de l'oscillateur sur la fréquence choisie sans être gêné par des dérives thermiques. Il est très facile d'avoir un résonateur présentant un facteur de qualité plus faible que celui du résonateur $Q_1$, étant donné que plusieurs paramètre influent sur le facteur de qualité du résonateur. Entrent en ligne de compte d'une part la qualité de la coupe et d'autre part, l'épaisseur et la disposition des électrodes. En effet, des électrodes épaisses à l'endroit où le résonateur vibre entrainent une baisse très importante du facteur de qualité. En pratique, ce sont les résonateurs de haute qualité qui présentent des facteurs de qualité élevés et sont très coûteux. Par contre, les résonateurs présentant des facteurs de qualité plus faible ou beaucoup plus faibles sont plus faciles à réaliser et sont bien meilleur marché. Il est de toutes façons possible de fabriquer un résonateur présentant un facteur de qualité déterminé. Par exemple, pour un résonateur $Q_1$ en quartz, on peut lui associer un résonateur $Q_2$ en tantalate de lithium.

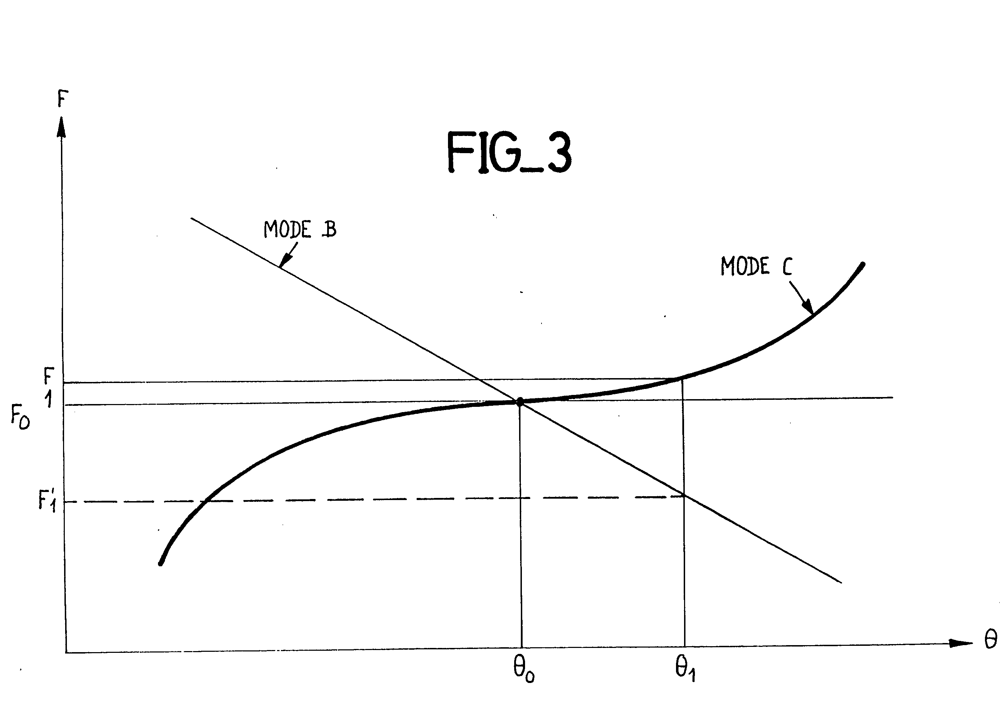

Selon la fig. 2, un oscillateur tel que décrit sur la fig. 1 est associé à un deuxième oscillateur présentant une dérive thermique importante. Si on se refère en effet à la fig. 3, un quartz en coupe SC présente pour son partiel 3 un mode C dont la courbe de dérive de fréquence en fonction de la température présente au voisinage d'une température $\Theta_0$ une pente faible et un mode B pratiquement linéaire dans une large gamme de température avec une dérive thermique élevée. Selon l'invention, on utilise le mode C du partiel 3 du quartz $Q_1$ comme référence de fréquence stable en température et on compense la légère dérive thermique de ce mode C en utilisant le mode B du même quartz comme capteur de température. Cette conception a pour avantage très important d'utiliser comme capteur de température le quartz lui-même dont on veut stabiliser la fréquence. On est donc sûr que la température mesurée est exactement celle qui est désirée.

En ce qui concerne la partie oscillateur sur le mode C, les mêmes éléments que ceux de la fig. 1 sont représentés avec les mêmes références. Cet oscillateur présente cependant en plus un circuit de commande de fréquence à diodes varicap $C_R$ de faible valeur encadrée de deux condensateurs $C_5$ et $C_6$ en série sur la base du transistor $T_1$. Une résistance de polarisation $R_5$ vient polariser la cathode de la diode varicap $C_R$ et une tension de commande $V_C$ est appliquée à l'anode de la diode varicap $C_R$ par l'intermédiaire d'une résistance de couplage $R_6$. Un tel circuit de commande de fréquence qui permet de faire varier légèrement la fréquence de l'oscillateur est d'ailleurs connu en soi. En outre, on adjoint en série dans le circuit de base du transistor $T_1$ un résonateur piézo-électrique $Q_3$ présentant un mode à la fréquence du mode de C du résonateur $Q_1$ correspondant à la fréquence désirée de l'oscillateur, avec un facteur de qualité de l'ordre de 30 à 1000 fois plus faible et de préférence de 30 à 100 fois plus faible. Le résonateur $Q_3$ permet d'améliorer la séparation entre les modes C sur lesquels fonctionne l'oscillateur principal et le mode B sur lequel fonctionne l'oscillateur utilisé comme capteur thermique.

L'oscillateur utilisé comme capteur thermique présente un montage Clapp similaire à celui de l'oscillateur de la fig. 1. Le collecteur d'un transistor $T_2$ est polarisé par une tension V par l'intermédiaire d'une résistance de polarisation $R_9$, et sa base par un pont diviseur R8, R4. En outre, un pont diviseur capacitif C3, C4 présentant un point dit point milieu $P_2$ est branché entre la base $B_2$ du transistor $T_2$ et la masse. L'émetteur $E_2$ du transistor $T_2$ est chargé par une résistance de charge $R_{10}$. Le résonateur piézo-électrique est branché entre l'émetteur E2 et le point milieu $P_2$. Il présente un mode dont la fréquence est celle du mode B voisin du mode C selon lequel fonctionne l'oscillateur principal. Il en est de même pour un résonateur $Q_4$ branché entre la base $B_2$ et l'électrode non à la masse du résonateur $Q_1$. Les résonateurs $Q_4$ et $Q_5$ présentent un facteur de qualité de 30 à 1000 fois plus faible et de préférence 100 fois plus faible que celui du mode B considéré du résonateur $Q_1$. La tension de sortie $S_T$ présente au collecteur $C_2$ du transistor $T_2$ est introduite dans un convertisseur fréquence-tension 1 qui sort une tension numérisée qui est introduite dans une mémoire 2.

Chaque valeur de la tension de sortie du convertisseur 1 correspond a une adresse dans la mémoire 2, adresse à laquelle est lue une tension mémorisée, à une cadence donnée par une horloge d'échantillonnage H. Cette tension mémorisée est le reflet de la correspondance entre les courbes de dérive thermique du mode B et du mode C du quartz Q1 et sa valeur correspond à celle de la tension $V_C$ qu'il faut introduire dans le circuit de variation de fréquence de l'oscillateur principal pour réaliser la correction de dérive thermique. A cet effet, chaque valeur lue dans la mémoire par la cadence de l'horloge d'échantillonnage est introduite dans un convertisseur numérique-analogique 3 dont la tension de sortie $V_C$ est appliquée à la résistance $R_6$.

## Revendications

1. Oscillateur piézo-électrique fonctionnant en mode apériodique, du type Clapp, comprenant un transistor ($T_1$), un pont diviseur capacitif ($C_1$, $C_2$) branché entre la base dudit transistor et la masse et présentant un point dit point milieu, une résistance ($R_3$) branchée entre l'émetteur du transistor et la masse, un premier résonateur piézo-électrique ($Q_1$) branché entre la base du transistor ($T_1$) et la masse, ce résonateur présentant une fréquence de résonance à laquelle l'oscillateur dit oscillateur primaire doit fonctionner, un second résonateur piézo-électrique ($Q_2$) branché entre ledit point milieu et l'émetteur du transistor ($T_1$), ce second résonateur jouant le rôle de filtre passe-bande à la fréquence de fonctionnement de l'oscillateur et ayant en commun avec le premier résonateur ($Q_1$) un mode à ladite fréquence de résonance, caractérisé en ce que le second résonateur ($Q_2$) a un facteur de qualité intrinsèque entre 30 et 1000 fois plus petit que celui du premier résonateur ($Q_1$) et en ce que l'oscillateur possède un circuit de détection de la température et un circuit d'asservissement de la température du premier résonateur ($Q_1$), ce premier résonateur présentant à ladite fréquence de résonance un mode de fréquence stable en fonction de la température ainsi qu'un mode dit thermométrique pour lequel la fréquence varie avec la température, le circuit de détection étant constitué par un oscillateur secondaire fonctionnant sur le mode thermométrique du premier résonateur et dont la fréquence varie en fonction de la température du premier résonateur, le circuit d'asservissement recevant, du circuit de détection, un signal ($S_T$) représentatif de la variation de température du premier résonateur et délivrant, à une diode varicap ($C_R$) placée dans la boucle d'oscillation de l'oscillateur primaire, un signal ($V_C$) permettant de compenser la dérive en fréquence de l'oscillateur primaire.

2. Oscillateur selon la revendication 1, caractérisé en ce que le premier résonateur ($Q_1$) est un quartz en coupe SC, en ce que le mode de fréquence stable est un mode C et le mode thermométrique est un mode B.

3. Oscillateur selon la revendication 2, caractérisé en ce que ledit mode C et ledit mode B appartiennent tous les deux au fondamental F ou à un partiel de même rang.

4. Oscillateur selon l'une quelconque des revendications 1 à 3, caractérisé en ce qu'il comporte un troisième résonateur piézo-électrique; ($Q_3$) ayant en commun avec le premier résonateur ($Q_1$) un

mode à ladite fréquence de résonance, mais dont le facteur de qualité est du même ordre de grandeur que celui du second résonateur ($Q_2$), le troisième résonateur ($Q_3$) étant disposé en série entre la borne non a la masse du premier résonateur ($Q_1$) et la base du transistor ($T_1$).

5. Oscillateur selon la revendication 4, caractérisé en ce que la diode varicap ($C_R$) est disposée en série avec le troisième résonateur ($Q_3$).

6. Oscillateur selon l'une quelconque des revendications 1 à 5, caractérisé en ce que l'oscillateur secondaire est un circuit similaire à celui de l'oscillateur primaire.

7. Oscillateur selon l'une quelconque des revendications 1 à 6, caractérisé en ce que le circuit d'asservissement comprend un convertisseur fréquence-tension (1) recevant ledit signal ($S_T$) issu du circuit de détection et dont la tension de sortie numérisée est introduite dans une mémoire (2) qui commande un convertisseur numérique-analogique (3) délivrant ledit signal ($V_C$) de compensation de la dérive en fréquence, une horloge d'échantillonnage (H) cadençant le fonctionnement des convertisseurs et de la mémoire.

**Patentansprüche**

1. Piezoelektrischer Oszillator, welcher aperiodisch arbeitet, vom Clapp-Typ, mit einem Transistor ($T_1$), einer kapazitiven Teilerbrücke ($C_1$, $C_2$), die zwischen die Basis dieses Transistors und Masse geschaltet ist und einen sogenannten Mittelpunkt aufweist und weiterhin versehen ist mit einem Widerstand ($R_3$), der zwischen den Emitter des Transistors und Masse geschaltet ist, einem ersten piezoelektrischen Resonator ($Q_1$), welcher zwischen die Basis des Transistors ($T_1$) und Masse geschaltet ist, wobei dieser Resonator eine Resonanzfrequenz aufweist, bei welcher der sogenannte primäre Oszillator arbeiten soll, einem zweiten piezoelektrischen Resonator ($Q_2$), der zwischen den genannten Mittelpunkt und den Emitter des Transistors ($T_1$) geschaltet ist, wobei dieser zweite Resonator die Funktion eines Bandpassfilters bei der Arbeitsfrequenz des Oszillators erfüllt und mit dem ersten Resonator ($Q_1$) einen Schwingungsmodus bei der Resonanzfrequenz aufweist, dadurch gekennzeichnet, dass der zweite Resonator ($Q_2$) einen Eigen-Gütefaktor aufweist, der zwischen 30- und 1000-mal kleiner als der des ersten Resonators ($Q_1$) ist, und dass der Oszillator eine Temperaturdetektionsschaltung und eine Schaltung zur Regelung der Temperatur des ersten Resonators ($Q_1$) aufweist, wobei dieser erste Resonator bei der genannten Resonanzfrequenz einen Schwingungsmodus als Funktion der Temperatur aufweist, welcher stabil ist, sowie einen sogenannten thermometrischen Schwingungsmodus aufweist, für welchen die Frequenz sich mit der Temperatur ändert, wobei die Detektionsschaltung aus einem sekundären Oszillator gebildet ist, der auf dem thermometrischen Schwingungsmodus des ersten Resonators arbeitet und dessen Frequenz sich in Abhängigkeit von der Temperatur des ersten Resonators ändert, wobei die Regelschaltung von der Detektionsschaltung ein Signal ($S_T$) empfängt, welches für die Temperaturänderung des ersten Resonators repräsentativ ist, und an eine Varicap-Diode ($C_R$), die in der Oszillatorschleife des Primäroszillators liegt, ein Signal ($V_C$) abgibt, durch welches die Kompensation der Frequenzabdrift des Primäroszillators ermöglicht wird.

2. Oszillator nach Anspruch 1, dadurch gekennzeichnet, dass der erste Resonator ($Q_1$) ein Quartz vom Schnitt SC ist, dass der Schwingungsmodus stabiler Frequenz ein C-Modus ist und der thermometrische Modus ein B-Modus ist.

3. Oszillator nach Anspruch 2, dadurch gekennzeichnet, dass der C-Modus und der B-Modus beide der Grundform F oder einer Teilform gleicher Ordnung angehören.

4. Oszillator nach einem der Ansprüche 1 bis 3, dadurch gekennzeichnet, dass er einen dritten piezoelektrischen Resonator ($Q_3$) umfasst, der mit dem ersten Resonator ($Q_1$) einen Schwingungsmodus bei derselben Resonanzfrequenz gemeinsam hat, dessen Gütefaktor jedoch in der gleichen Grössenordnung wie der des zweiten Resonators ($Q_2$) liegt, wobei der dritte Resonator ($Q_3$) in Reihe zwischen dem nicht mit Masse verbundenen Anschluss des ersten Resonators ($Q_1$) und der Basis des Transistors ($T_1$) geschaltet ist.

5. Oszillator nach Anspruch 4, dadurch gekennzeichnet, dass die Varicap-Diode ($C_R$) in Reihe mit dem dritten Resonator ($Q_3$) geschaltet ist.

6. Oszillator nach einem der Ansprüche 1 bis 5, dadurch gekennzeichnet, dass der sekundäre Oszillator eine Schaltung ist, die der des primären Oszillators gleicht.

7. Oszillator nach einem der Ansprüche 1 bis 6, dadurch gekennzeichnet, dass die Regelschaltung einen Frequenz/Spannungs-Umsetzer (1) umfasst, welcher das von der Detektionsschaltung abgegebene Signal ($S_T$) empfängt und dessen digitalisierte Ausgangsspannung in einen Speicher (2) eingegeben wird, welcher einen Digital/Analog-Umsetzer (3) steuert, der das genannte Frequenzabdrift-Kompensationssignal ($V_C$) abgibt, wobei ein Abtast-Taktgeber (H) die Funktion der Umsetzer und des Speichers taktet.

**Claims**

1. An aperiodically functioning piezo-electric oscillator of the Clapp type, comprising a transistor ($T_1$), a capacitive dividing bridge ($C_1$ and $C_2$) connected in circuit between the base of the said transistor and ground and having a point termed the center point, a resistor ($R_3$) connected between the emitter of the transistor and ground, a first piezo-electric resonator ($Q_1$) connected between the base of the transistor ($T_1$) and ground, such resonator having a resonant frequency at which the said oscillator, termed the primary oscillator, is to function, a second piezo-electric resonator ($Q_2$) connected between the said center point and the emitter of the transistor ($T_1$), said second resonator playing the role of a pass band filter at the operating frequency of the oscillator and having one mode at the said resonant frequency in common with the said first resonator ($Q_1$), characterized in that the second resonator ($Q_2$) has an intrinsic quality factor between 30 and 1000 times less than that of the first resonator ($Q_1$) and in that the oscillator possesses a temperature responsive circuit and a circuit for the automatic control of the temperature of the first resonator ($Q_1$), said first resonator presenting at the said resonant frequency a frequency mode which is stable as a function of the temperature and a mode, termed the thermometric mode, in which the frequency varies with temperature, the said responsive circuit being constituted by a secondary oscillator functioning in the thermometric mode of the first resonator and whose frequency varies as a function of the temperature of the first resonator, said automatic control circuit receiving, from the said responsive circuit, a signal ($S_T$) representative of the variation of temperature of the first resonator and supplying a signal ($V_C$) permitting compensation of the drift at the frequency of the primary oscillator to a varicap diode ($C_R$) placed in the oscillation loop of the primary oscillator.

2. The oscillator as claimed in claim 1, characterized in that the primary resonator ($Q_1$) is a quartz with an SC cut, in that the stable frequency mode is a C mode and in that the thermometric mode is a B mode.

3. The oscillator as claimed in claim 2, characterized in that the said C mode and the said B mode both belong to fundamental form F or to a partial form of the same order.

4. The oscillator as claimed in any one of the claims 1 through 3, characterized in that it comprises a third piezo-electric resonator ($Q_3$) having a mode at the said resonant frequency in common with the first resonator ($Q_1$), but whose quality factor is of the same order of size as that of the second resonator ($Q_2$), the third resonator ($Q_3$) being placed in series with the non-grounded terminal of the first resonator ($Q_1$) and the base of the transistor ($T_1$).

5. The oscillator as claimed in claim 4, characterized in that the varicap diode ($C_R$) is placed in series with the third resonator ($Q_3$).

6. The oscillator as claimed in any one of the claims 1 through 5, characterized in that the secondary oscillator is a circuit similar to that of the primary oscillator.

7. The oscillator as claimed in any one of the claims 1 through 6, characterized in that the automatic control circuit comprises a frequency-voltage converter (1) receiving the said signal ($S_T$) issued by the said responsive circuit and whose digitalized output voltage is introduced into a memory (2) which controls a digital-analog converter (3) supplying the said signal ($V_C$) for compensation of frequency drift, a sampling clock (H) clocking the operation of the converters and of the memory.

# FIG_1

# FIG_2

# FIG_3

MODE B

MODE C

$F_1$

$F_0$

$F'_1$

$\theta_0$  $\theta_1$  $\theta$

F

0157697

6